# EUROPEAN PATENT SPECIFICATION

(11) **EP 2 751 300 B1**
(45) Date of publication and mention of the grant of the patent: **24.10.2018**
(21) Application number: 12769893.4
(22) Date of filing: 31.08.2012
(51) Int. Cl.: C23C 14/06, H01L 35/18, H01L 35/34, C23C 14/14

(54) **A THERMOELECTRIC ZINC ANTIMONIDE THIN FILM**
THERMOELEKTRISCHE ZINKANTIMONID-DÜNNSCHICHT
COUCHE MINCE D'ANTIMONIURE DE ZINC THERMOÉLECTRIQUE

(30) Priority: 31.08.2011 DK 201170483
(43) Date of publication of application: 09.07.2014
(73) Proprietor: Aarhus Universitet, 8000 Aarhus C (DK)
(72) Inventor: SUN, Ye, Harbin Heilongjiang 150080 (CN); CHRISTENSEN, Mogens, DK-8200 Aarhus N (DK); IVERSEN, Bo Brummerstedt, DK-8541 Skødstrup (DK)
(74) Representative: Plougmann Vingtoft a/s
(86) International application number: PCT/DK2012/050324
(87) International publication number: WO 2013/029629

(56) References cited:
- US-A1- 2007 084 495
- US-A1- 2007 125 413

## Description

### FIELD OF THE INVENTION

The present invention relates to thermoelectric materials, and in particular to a method for producing a thermoelectric zinc antimonide thin film, a thermoelectric zinc antimonide thin film and use of a thermoelectric zinc antimonide thin film.

### BACKGROUND OF THE INVENTION

Thermoelectric materials (TMs) can be used for direct conversion between electrical energy and thermal energy, both of which have been extensively involved in modern civilizations. Considered as one kind of novel materials for clean and sustainable energy, TMs can be employed in power generators that convert industrial, domestic and natural waste heat to electricity, thus to improve energy efficiency and/or to fabricate self-powered devices. In addition, TMs can also be fabricated in solid-state refrigeration and thermoelectric sensors. Combined with modern device fabrication technology, TMs have substantial application potential in electronics.

The efficiency of TMs is evaluated using the dimensionless figure of merit, i.e. *zT = S*²*T*/(*ρκ*)*,* where *S* is the Seebeck coefficient, *T* is the absolute temperature, *ρ* is the resistivity, and *κ* is the thermal conductivity. TMs with *zT* significantly higher than 1 are required to make a thermoelectric device commercially competitive. In the last decade some remarkable progress on TMs has been achieved on complex materials and nanostructured materials. For example, it has been reported that AgPb₁₈SbTe₂₀ bulk samples could have *zT* of 1.7 at 700 K.

The reference "Thin-film thermoelectric devices with high room-temperature figures of merit" by Venkatasubramanian, R., Siilvola, E., Colpitts, T. & O'Quinn, B., Nature 413, 597-602 (2001), reports a high *zT* value of 2.4 from Bi₂Te₃/Sb₂Te₃ superlattices produced by molecular beam epitaxy (MBE). However, commercial application of TMs is still restricted by their relatively low efficiency and high cost. In particular, very high cost on raw elemental materials, such as Te, Ag, Yb, Ce etc., and on production techniques, such as MBE prevents widespread application of most TMs.

Hence, an improved thermoelectric material would be advantageous, and in particular a more efficient, cheap and/or reliable thermoelectric material would be advantageous.

### SUMMARY OF THE INVENTION

It is a further object of the present invention to provide an alternative to the prior art.
In particular, it may be seen as an object of the present invention to provide an improved thermoelectric material, and in particular to provide a more efficient, cheap and/or reliable thermoelectric material that solves the above mentioned problems of the prior art.
Thus, the above described object and several other objects are intended to be obtained in a first aspect of the invention by providing a method for manufacturing a phase pure thermoelectric zinc antimonide thin film, the method comprising deposition of zinc and antimony on a substrate wherein the deposited zinc and antimony form a layer of zinc antimonide, wherein the substrate during deposition has a temperature of at least 100 degrees Celsius, such as within 100-1110 degrees Celsius, such as within 100-1000 degrees Celsius, such as within 100-400 degrees Celsius.

The invention is particularly, advantageous for obtaining a a phase pure thermoelectric zinc antimonide thin film.

The gist of the invention may be regarded as the insight, that deposition of zinc and antimony on a hot substrate may enable fabrication of thermoelectric zinc antimonide thin films, such as thermoeleric zinc antimonide thin films of high quality, such as thermoelectric zinc antimonide thin films which are phase pure, such as thermoelectric zinc antimonide thin films with controlled composition.

Another possible advantage of the invention may be that it enables production of hitherto unknown phases of thermoelectric zinc antimonide thin film.

By 'thin film' is understood a layer of material ranging from fractions of a nanometer (monolayer) to several micrometers in thickness. It may also be understood that a thin film is a thin structure which has a relatively large size in a first and/or second direction, which first and second directions are orthogonal to each other, such as defining a plane, while the size in the direction orthogonal to the first and second direction is substantially smaller.

By 'deposition' is understood the process of placing a material, such as an element, on a surface.

By 'substrate' is understood a solid material with a surface suitable for deposition.

According to an embodiment, there is presented a method wherein the substrate during deposition has a temperature of at least 200 degrees Celsius, such as at least 250 degrees Celsius, such as at least 300 degrees Celsius, such as within 200-1110 degrees Celsius, such as within 250-1000 degrees Celsius, such as within 300 to 1000 degrees Celsius, such as within 250-400 degrees Celsius, such as within 300-400 degrees Celsius. A possible advantage of having such high temperature of the substrate may be that it enables more efficient production of thermoelectric zinc antimonide thin film, such as enables skipping a subsequent annealing step.

According to an embodiment, there is presented a method wherein the zinc and the antimony is deposited in quantities corresponding to an atomic zinc:antimony ratio within 70:30 and 40:60, such as within 60:40 and 40:60, such as within 59:41 and 41:59, such as within 58:42 and 42:58, such as within 57:43 and 43:57, such as within 56:44 and 44:56, such as within 55:45 and 45:55, such as within 54:46 and 46:54, such as within 53:47 and 47:53, such as within 52:48 and 48:52, such as within 51:49 and 49:51, such as substantially 50:50, such as 50:50, such as within 60:40 and 48:52, such as within 59:41 and 49:51, such as within 58:42 and 50:50, such as within 57:43 and 51:49, such as within 56:44 and 52:48, such as within 55:45 and 53:47, such as substantially 54:46, such as 54:46, such as within 70:30 and 40:60, such as within 70:30 to 55:45, such as within 70:30 and 56:44, such as within 60:40 and 56:44, such as within 59:41 and 57:43, such as substantially 58:42, such as 58:42.

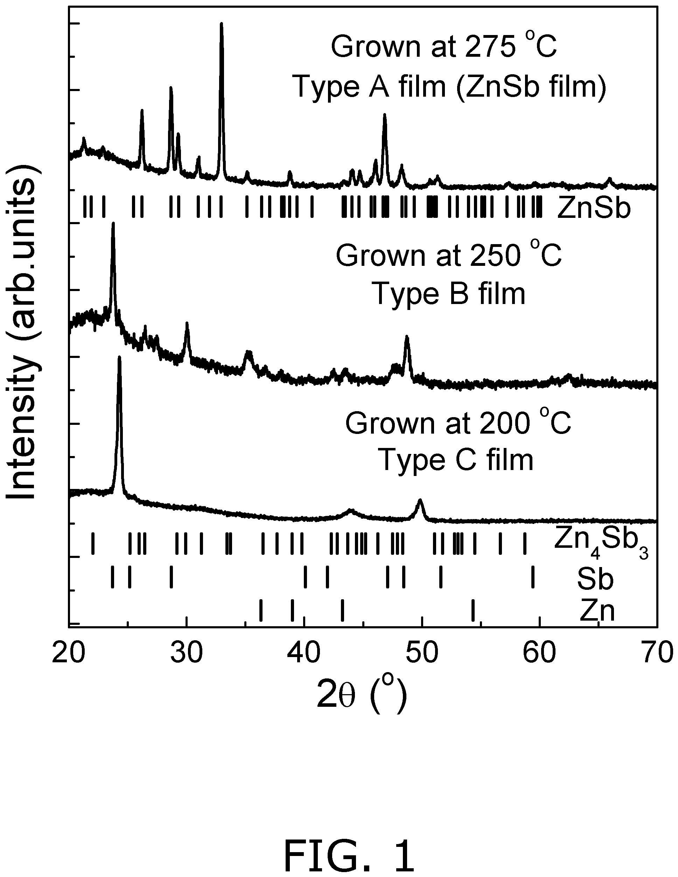

According to an embodiment, there is presented a method wherein the method further comprises an annealing step, wherein the substrate subsequent to deposition of zinc and antimony is kept at an elevated temperature for a period of time, such as a temperature within 473-837 Kelvin, such as within 473-773 Kelvin, such as within 473-673 Kelvin, such as within 473-623 Kelvin, such as within 523-623 Kelvin, such as within 573-623 Kelvin, for a period of time. A possible advantage of including an annealing step in the method may be, that it enables thermoelectric zinc antimonide thin films comprising various zinc antimonide phases to be produced, such as enables phase transformation from a type C film (as shown in FIG 1 in the lower graph labelled 'Type C film') to a Zn4Sb3 film, such as enabling phase transformation from a type B (as shown in FIG 1 in the middle graph labelled 'Type B film') film to a Zn4Sb3+ZnSb film.

By 'annealing' is understood as is common in the art as a process where heat is supplied, such as a process comprising heating to above a recrystallization temperature, maintaining a suitable temperature for a period of time, and then cooling.

According to an embodiment, there is presented a method wherein said period of time is within 0.01-72 hours, such as within 0.01-24 hours, such as within 0.1-24 hours, such as within 0.5-24 hours, such as within 1-24 hours, such as within 1-12 hours, such as within 1-6 hours, such as within 1-3 hours, such as 2-3 hours, such as 0.01-3 hours, such as at least 2 hours, such as at most 3 hours, such as 2 hours.

According to an embodiment, there is presented a method wherein the zinc and/or the antimony is placed on the substrate using vapour deposition, such as physical vapour deposition, such as chemical vapour deposition, such as sputtering, such as sputter deposition, such as magnetron sputtering. In a particular embodiment, the zinc and/or the antimony is placed on the substrate using vapour deposition being chosen from the group comprising physical vapour deposition and chemical vapour deposition. Sputter deposition, such as magnetron sputtering, is a physical vapour deposition (PVD) method of depositing thin films by sputtering, that is ejecting, material from a "target", wherein the "target" is understood to be a source material, which then deposits onto a "substrate," such as a silicon wafer. In a particular embodiment, the method employs a plurality of targets, such as co-sputtering, such as at least a first and a second target, where the first and the second target does not have the same concentration of Zn and/or Sb. An advantage of employing a plurality of targets may be that it enables controlling the ratio of Zn and Sb which is deposited on the substrate.

According to a second aspect of the invention, the invention further relates to a thermoelectric zinc antimonide thin film wherein the thermoelectric zinc antimonide thin film is phase pure ZnSb. In an alternative embodiment, the invention further relates to a thermoelectric zinc antimonide thin film with at least 0.1 wt% being the ZnSb phase, such as at least 1 wt% being the ZnSb phase, such as at least 2.5 wt% being the ZnSb phase, such as at least 5 wt% being the ZnSb phase, such as at least 10 wt% being the ZnSb phase, such as at least 15 wt% being the ZnSb phase, such as at least 20 wt% being the ZnSb phase, such as at least 25 wt% being the ZnSb phase, such as at least 30 wt% being the ZnSb phase, such as at least 35 wt% being the ZnSb phase, such as at least 40 wt% being the ZnSb phase, such as at least 45 wt% being the ZnSb phase, such as at least 50 wt% being the ZnSb phase, such as at least 55 wt% being the ZnSb phase, such as at least 60 wt% being the ZnSb phase, such as at least 65 wt% being the ZnSb phase, such as at least 70 wt% being the ZnSb phase, such as at least 75 wt% being the ZnSb phase, such as at least 80 wt% being the ZnSb phase, such as at least 85 wt% being the ZnSb phase, such as at least 90 wt% being the ZnSb phase, such as at least 95 wt% being the ZnSb phase, such as at least 97 wt% being the ZnSb phase, such as at least 98 wt% being the ZnSb phase, such as at least 99.0 wt% being the ZnSb phase, 99.5 wt% being of the ZnSb phase, such as at least 99.9 wt% being the ZnSb phase, such as 100 wt% being the ZnSb phase. In a particular embodiment, the quantity of ZnSb in the thin films can be controlled to be between 0-100 wt%, such as between 90-100 wt%.

According to a third aspect of the invention, the invention further relates to a thermoelectric zinc antimonide thin film wherein the thermoelectric zinc antimonide thin film phase pure Zn4Sb3. In an alternative embodiment, the invention further relates to a thermoelectric zinc antimonide thin film with at least 0.1 wt% being the Zn4Sb3 phase, such as at least 1 wt% being the Zn4Sb3 phase, such as at least 2.5 wt% being the Zn4Sb3 phase, such as at least 5 wt% being the Zn4Sb3 phase, such as at least 10 wt% being the Zn4Sb3 phase, such as at least 15 wt% being the Zn4Sb3 phase, such as at least 20 wt% being the Zn4Sb3 phase, such as at least 25 wt% being the Zn4Sb3 phase, such as at least 30 wt% being the Zn4Sb3 phase, such as at least 35 wt% being the Zn4Sb3 phase, such as at least 40 wt% being the Zn4Sb3 phase, such as at least 45 wt% being the Zn4Sb3 phase, such as at least 50 wt% being the Zn4Sb3 phase, such as at least 55 wt% being the Zn4Sb3 phase, such as at least 60 wt% being the Zn4Sb3 phase, such as at least 65 wt% being the Zn4Sb3 phase, such as at least 70 wt% being the Zn4Sb3 phase, such as at least 75 wt% being the Zn4Sb3 phase, such as at least 80 wt% being the Zn4Sb3 phase, such as at least 85 wt% being the Zn4Sb3 phase, such as at least 90 wt% being the Zn4Sb3 phase, such as at least 95 wt% being the Zn4Sb3 phase, such as at least 97 wt% being the Zn4Sb3 phase, such as at least 98 wt% being the Zn4Sb3 phase, such as at least 99.0 wt% being the Zn4Sb3 phase, 99.5 wt% being of the Zn4Sb3 phase, such as at least 99.9 wt% being the Zn4Sb3 phase, such as 100 wt% being the Zn4Sb3 phase. In a particular embodiment, the quantity of Zn4Sb3 in the thin films can be controlled to be between 0-100 wt%, such as between 90-100 wt%.

By 'phase pure' is understood that only one phase is present. The phase purity may be assessed with XRD. In an XRD spectrum of a phase pure sample, only peaks which can be assigned to the particular phase should be present.

A possible advantage of phase pure thermoelectrical zinc antimonide thin films may be that they are thermally stable. It has previously been shown, that phase purity is beneficial for thermal stability. By stability is understood that a first parameter, such as Seebeck coefficient, such as electrical conductivity, remains constant, such as substantially constant, with respect to a second parameter, such as temperature, such as time. It is understood that the first parameter need not be exactly constant, but may also be termed stable if it is substantially constant although varying within a relatively small range, such as within 0.1 %, such as within 1 % such as within 10 %, such as within a measurement uncertainty.

It should be noted that in the present application and in the appended claims, the term "a material having the stoichiometric formula Zn4Sb3" or "a phase having the Zn4Sb3 stoichiometry" is to be interpreted as a material having a stoichiometry which traditionally and conventionally has been termed Zn4Sb3 and having a Zn4Sb3 crystal structure. However, it has recently been found that these materials having the Zn4Sb3 crystal structure contain interstitial zinc atoms making the exact stoichiometry Zn12.82Sb10, equivalent to the stoichiometry Zn3.846Sb3 (cf. Disordered zinc in Zn4Sb3 with Phonon Glas, Electron Crystal Thermoelectric Properties, Snyder, G. J.; Christensen, M.; Nishibori, E.; Rabiller, P.; Caillat, T.; Iversen, B. B., Nature Materials 2004, 3, 458-463; and Interstitial Zn atoms do the trick in Thermoelectric Zinc Antimonide, Zn4Sb3. A combined Maximum Entropy Method X-Ray Electron Density and an Ab Initio Electronic Structure Study, Caglioni, F.; Nishibori, 20 E.; Rabiller, P.; Bertini, L.; Christensen, M.; Snyder, G. J.; Gatti, C.; Iversen, B. B., Chem. Eur. J. 2004, 10, 3861-3870).

The present application it is also conceived to encompass having other elements in the zinc antimonide thin film, such as for example substitution of one or more elements selected from the group comprising Sn, Mg, Pb and the transition metals in a total amount of 20 mol% or less, such as within 0.01-20 %, in relation to the Zn atoms.

In a particular embodiment of the present invention, the Zn₄Sb₃ phase is β-Zn₄Sb₃ (beta-Zn₄Sb₃).

Hereinafter, "Zn4Sb3" is used interchangeably with "a material having the stoichiometric formula Zn4Sb3". "Zn4Sb3" is used interchangeably with "Zn₄Sb₃".

According to an embodiment, there is presented a thermoelectric zinc antimonide thin film wherein the thermoelectric zinc antimonide thin film has a thickness within 1-100000 nm, such as within 10-10000 nm, such as within 100-1000 nm, such as within 200-800 nm, such as within 300-600 nm, such as within 400-600 nm, such as within 400-1500 nm, such as within 400-1000 nm. The zinc antimonide thin film thickness may be adjusted, such as by varying the growth time, since the thickness increases with the growth time. The growth rate of the film may be about 200-300 nm/hour, which is the case using our current sputtering system. A relatively thin, such as 1-5000 nm, such as 1-1000 nm, such as 1-200 nm, such as 1-100 nm such as 1-50 nm, such as 1-10 nm, such as 1-5 nm, thermoelectric zinc antimonide thin film may be particularly advantageous for certain applications, such as sensor applications. A relatively thick, such as 1000-100000 nm, such as within 1000-10000 nm, such as within 5000-100000 nm, such as 5000-10000 nm, thermoelectric zinc antimonide thin film may be particularly advantageous for certain applications, such as thermoelectric generator or thermoelectric cooler applications.

According to an embodiment, there is presented a thermoelectric zinc antimonide thin film wherein the thermoelectric zinc antimonide thin film has a power factor of at least 1.0x10⁻⁴ Wm⁻¹K⁻² at 573 K, such as at least 5.0x10⁻⁴ Wm⁻¹K⁻² at 573 K, such as at least 10.0x10⁻⁴ Wm⁻¹K⁻² at 573 K, such as at least 11.0x10⁻⁴ Wm⁻¹K⁻² at 573 K, such as at least 12.0x10⁻⁴ Wm⁻¹K⁻² at 573 K, such as at least 13.0x10⁻⁴ Wm⁻¹K⁻² at 573 K, such as at least 14.0x10⁻⁴ Wm⁻¹K⁻² at 573 K, such as at least 15.0x10⁻⁴ Wm⁻¹K⁻² at 573 K, such as at least 16.0x10⁻⁴ Wm⁻¹K⁻² at 573 K, such as at least 16.5x10⁻⁴ Wm⁻¹K⁻² at 573 K, such as at least 18.0x10⁻⁴ Wm⁻¹K⁻² at 573 K, such as at least 20.0x10⁻⁴ Wm⁻¹K⁻² at 573 K. An advantage of having a high power factor (PF=S²/ρ) may be that the since PF scales with figure of merit zT (zT = S²T/(ρκ)), then the (with T and κ not changed), the higher the power factor, the higher the zT value.

According to an embodiment, there is presented a thermoelectric zinc antimonide thin film wherein the power factor is measured after one complete thermal cycle, such as after two complete thermal cycles, wherein a thermal cycle is understood to be the process of changing the temperature of the thermoelectric thin film from room temperature, such as 300 Kelvin, to 560 Kelvin and back to room temperature, such as 300 Kelvin, such as 326 K. An advantage of measuring the power factor after one or more thermal cycles may be that the thus measured value represents a more realistic value in terms of the real life performance, since in real life applications, the thermoelectric zinc antimonide thin film is highly likely to undergo thermal cycling during use. Room temperature is generally known in the field to be a temperature understood to be within 18-30 degrees Celsius, such as within 20-25 degrees Celsius, such as 18 degrees Celsius, such as 20 degrees Celsius, such as 25 degrees Celsius, such as 300 Kelvin, such as 30 degrees Celsius.

For measuring the thermoelectric properties of the thermoelectric zinc antimonide thin films at various temperatures, the thermoelectric zinc antimonide thin films may be kept at a special, defined temperature (such as 300 K or 573 K) and then have its properties measured. For measuring the thermoelectric properties during thermal cycling, the upper and lower temperatures may be defined, and optionally how many data points one wants to obtain, and then allow the measurement system to automatically perform the measurement at the different temperatures.

According to a fourth aspect of the invention, the invention further relates to a thermoelectric zinc antimonide thin film prepared according to the first aspect.

According to a fifth aspect of the invention, the invention further relates to a thermoelectric zinc antimonide thin film which has X-ray powder diffraction peaks at 23.8, 30.1 and 48.8 degrees two-theta with copper (Cu) as an X-ray source. This aspect of the invention is particularly, but not exclusively, advantageous in that the thermoelectric zinc antimonide thin film according to the present aspect may be useful for production of Zn4Sb3+ZnSb thermoelectric zinc antimonide thin films. It is noted that the thermoelectric zinc antimonide thin film according to the fifth aspect is similar to the type B film. In a particular embodiment, the thermoelectric zinc antimonide thin film of type B has a resistivity of at least 1 mΩcm (milliohm x centimeter), such as at least 5 mΩcm, such as at least 10 mΩcm, such as at least 50 mΩcm, such as at least 100 mΩcm, such as at least 1000 mΩcm, such as at least 10000 mΩcm, such as at least 100000 mΩcm, such as at least 500000 mΩcm, such as substantially 650000 mΩcm, such as within 5-1000000 mΩcm, such as within 50-1000000 mΩcm, such as within 100000-1000000 mQcm.

According to a sixth aspect of the invention, the invention further relates to a thermoelectric zinc antimonide thin film which has X-ray powder diffraction peaks at 24.4, 43.9 and 49.9 degrees two-theta with copper (Cu) as an X-ray source. This aspect of the invention is particularly, but not exclusively, advantageous in that the thermoelectric zinc antimonide thin film according to the present aspect may be useful for production of Zn4Sb3 thermoelectric zinc antimonide thin films. It is noted that the thermoelectric zinc antimonide thin film according to the fifth aspect is similar to the type C film. In a particular embodiment, the thermoelectric zinc antimonide thin film of type C has a resistivity of at least 0.1 (milliohm x centimeter), such as at least 4 mΩcm, such as at least 7 mΩcm, such as at least 10 mΩcm, such as at least 20 mΩcm, such as at least 30 mΩcm, such as at least 40 mΩcm, such as substantially 43 mΩcm, such as within 4-1000 mΩcm, such as within 10-100 mΩcm, such as within 25-100 mΩcm. In another particular embodiment, the thermoelectric zinc antimonide thin film of type C has a carrier concentration of at most 1 × 10²¹ cm⁻³, (per cubic centimeter), such as at most 2.5 × 10²⁰ cm⁻³, such as at most 1 × 10²⁰ cm⁻³, such as at most 8 × 10¹⁹ cm⁻³, such as at most 6 × 10¹⁹ cm⁻³, such as at most 5 × 10¹⁹ cm⁻³, such as at most 4 × 10¹⁹ cm⁻³, such as substantially 3.6 × 10²⁰ cm⁻³, such as within 1 × 10¹⁹ - 2 × 10²⁰ cm⁻³, such as within 2 × 10¹⁹ - 2 × 10²⁰ cm⁻³, such as within 2 × 10¹⁹ - 1 × 10²⁰ cm⁻³.

According to a seventh aspect of the invention, the invention further relates to use of a thermoelectric zinc antimonide thin film according to any one of the second, third, fourth, fifth or sixth aspect, for converting thermal energy, such as heat, into electrical energy, for converting electrical energy into thermal energy, for cooling and/or for sensing. In an exemplary embodiment the invention further relates to use of a thermoelectric zinc antimonide thin film according to any one of the fifth or sixth aspect for producing a thermoelectric zinc antimonide thin film. In a specific embodiment the invention further relates to use of a thermoelectric zinc antimonide thin film according to the sixth aspect to produce a thermoelectric zinc antimonide thin film according to the third aspect. In another specific embodiment the invention further relates to use of a thermoelectric zinc antimonide thin film according to the fifth aspect for production of a thermoelectric thin film comprising Zn4Sb3 and ZnSb.

In an embodiment according to the first aspect, a thermoelectric zinc antimonide thin film, such as Zn4Sb3, is produced directly, such as rendering the annealing step superfluous.

It is understood, that the direct formation of Zn4Sb3 films requires a relatively high substrate temperature, such as at least 503 K. Due to the relatively high vapour pressure of Zn, this also means that we need to deposit more zinc on the substrate surface. It is contemplated that a number of methods could help to put some more zinc on the substrate surface, such as:
- utilizing a target with a high concentration of Zn,
- an increased magnetron power (MP_{Zn} target) of a target with a relatively high Zn concentration,
- larger size of the target with a high concentration of Zn,
- the employment of further targets comprising Zn, such as a second, third, fourth, target comprising Zn,
- adjustment of the Ar pressure,
- adjustment of the distance between the target comprising Zn, such as the target with a relatively high concentration of Zn, and the substrate surface.
It is understood that the methods in the list above may be employed alone or in any combination.

In a particular embodiment according to the first aspect, there is provided a method, wherein Zn and Sb are deposited on the substrate using a compound target with a Zn:Sb atomic ratio of at least 60:40, such as the Zn:Sb atomic ratio being at least 1.5, such as within 60:40 to 80:20. The target may be realized by, for example, the following steps:
- mixing powders of elemental zinc and elemental antimony so as to obtain a mixed powder comprising elemental zinc and elemental antimony, such as a Zn:Sb atomic ratio of at least 60:40, such as the Zn:Sb atomic ratio being at least 1.5, such as within 60:40 to 80:20,
- placing the mixed powder in a container, such as a die, and
- performing a combined synthesis and sintering process comprising
- applying a pulsed current through the mixed powder, so as to increase the temperature of the mixed powder to an interval within 200-1000 degree Celsius, and
- applying a pressure of at least 1 Mega Pascal, such as 10-20 MPa, such as 20-30 MPa, such as 30-40 MPa, such as 40-50 MPa, such as 50-60 MPa, such as 60-70 MPa, such as 70-80 MPa, such as 80-90 MPa, such as 90-100 MPa, such as 100-110 MPa, such as 100-200 MPa to the mixed powder, and
wherein the steps of applying the pulsed current through the mixed powder and applying the pressure to the mixed powder occur simultaneously.

A possible advantage of this method may be that the Zn4Sb3 film will be realized directly after deposition, i.e., rendering a subsequent annealing step superfluous.

In another particular embodiment according to the first aspect, there is presented a method according for preparing a thermoelectric zinc antimonide thin film comprising Zn4Sb3 wherein the Zn and Sb are deposited on a substrate, where the substrate has a temperature of at least 503 K, such as within 503-837 K, such as within 503-773 K, such as within 503-673 K, such as within 523-837 K, such as within 523-773 K, such as within 573-673, such as within 573-837 K, such as within 573-773 K, such as within 573-673.

In another particular embodiment according to the first aspect, there is provided a method for preparing a thermoelectric zinc antimonide thin film comprising Zn4Sb3, wherein Zn and Sb are deposited on the substrate using at least a first and a second target, wherein the zinc concentration in the first target is higher than the zinc concentration in the second target, and wherein the magnetron power of the first target is higher, such as substantially higher, during deposition than the magnetron power of the second target, and wherein the substrate temperature is at least 503 K, such as within 503-837 K, such as within 503-773 K, such as within 503-673 K, such as within 523-837 K, such as within 523-773 K, such as within 573-673, such as within 573-837 K, such as within 573-773 K, such as within 573-673.

A possible advantage of this method may be that the Zn4Sb3 film will be realized directly during and/or after deposition, i.e., rendering a subsequent annealing step superfluous.

The deposition of the Zn and Sb may in a particular embodiment be performed with the magnetron power of the second target (MP_{compound target}) of 1-10 W, such as 6-10 W, and the magnetron power of the first target (MP_{Zn target}) of 10-200 W, such as 10-20 W, such as 12-20 W, such as 15-20 W, such as 18-20 W. Exemplary values of P, Ar flow rate and substrate temperature T_{sub}, may be given by P of 0.6-1.5 Pa, Ar flow rate of 10 sccm, T_{sub} of 573-623 K, and deposition time t of 0.1-24 hr, such as 1-3 hr.

It is noted that the growth parameters presented here applies to the specific sputtering system. The sputtering system used in this work is a home-made Direct Current (DC) magnetron sputtering system. The sputtering system was equipped with two independent DC magnetron sources with a target-to-substrate distance of 10 cm. It is understood that for other systems the Ar pressure, the Ar flow rate, and magnetron power applied could be different. The deposition time is related to the film thickness, so the deposition time could be longer than 1-3 hr, even 24 hour, or even longer depending on the design of the system and the target thickness.

The first, second, third, fourth, fifth, sixth and seventh aspect of the present invention may each be combined with any of the other aspects. These and other aspects of the invention will be apparent from and elucidated with reference to the embodiments described hereinafter.

### BRIEF DESCRIPTION OF THE FIGURES

The method for producing a thermoelectric zinc antimonide thin film, a thermoelectric zinc antimonide thin film and use of a thermoelectric zinc antimonide thin film according to the invention will now be described in more detail with regard to the accompanying figures. The figures show one way of implementing the present invention and is not to be construed as being limiting to other possible embodiments falling within the scope of the attached claim set.
FIG 1 shows XRD patterns of samples grown at various conditions,
FIG 2 shows XRD patterns of samples grown at various conditions,
FIG 3 shows physical properties of a ZnSb film as a function of temperature,
FIG 4 shows physical properties of a type C film as a function of temperature,
FIG 5 shows power factor of an annealed type C film,
FIG 6 shows estimates of zT values of the ZnSb and Zn4Sb3 films,
FIG 7 is a flow-chart of a method according to the invention.

### DETAILED DESCRIPTION OF AN EMBODIMENT

Zn₄Sb₃ and ZnSb are promising p-type thermoelectric materials (TMs) with high thermoelectric performance and low cost, which present significant advantages for commercial application compared to other TMs working at 473 K to 673 K. Here, ZnSb films and another two types of zinc antimonide films with new crystal phases were directly produced on silica substrates by a co-sputtering method. After annealing (where the annealing step takes place after the deposition step) treatments at 573 K, the two types of new-phase films separately changed into Zn₄Sb₃+ZnSb and nearly phase-pure, such as phase-pure, Zn₄Sb₃ films. The phase transitions of these films were confirmed by the changes of their X-Ray diffraction patterns and electrical properties. The thermoelectric properties of the different types of zinc antimonide films were studied. The Zn₄Sb₃ and ZnSb films were confirmed to have very large power factor values comparable to the best reported results of the bulk materials and have good stability at 573 K. This implies a remarkable application potential for thermoelectric power generators and sensors.

β-Zn₄Sb₃, which is stable at 250-673 K, is a promising *p*-type TM at moderate temperature due to its significantly lower lattice thermal conductivity. The highest *zT* value of Zn₄Sb₃ is reported to be 1.3 at 670 K. In comparison with the recently discovered excellent TMs working in the same temperature range (473 K to 673 K), i.e. TAGS ("TeSbGeAg" phases) and LAST ("PbSbAgTe" phases), Zn₄Sb₃ has overwhelming advantages on its commercial application potential owing to the low cost, abundancy and low toxicity of the Zn and Sb elements. However, the thermal stability study revealed that Zn₄Sb₃ could decompose into ZnSb, Zn and Sb at high temperature, which will degrade its long-term thermoelectric performance. It is worth noting that ZnSb is also a good *p*-type TM. ZnSb is reported to have large power factor values (PF=*S*²/*ρ*) comparable to Zn₄Sb₃, but its high thermal conductivity restrict its highest reported *zT* value to 0.6 at 500 K. To improve practical application of Zn₄Sb₃ and ZnSb, numerous works has been performed to study thermoelectric properties and stability of zinc antimonide bulk materials. However, there is only few works exploring growth and thermoelectric properties of zinc antimonide films which have been reported.

Thermoelectric coolers fabricated from thin-film superlattices have been reported to be integrated into state-of-the-art electronic packages. This technique implies promising potential of thermoelectric thin films to be applied in cooling, sensing and self-powered devices. Furthermore, due to surface and grain-boundary scattering of phonons, thermoelectric thin films could have much reduced lattice thermal conductivity and thus enhanced *zT* values compared to the bulk TMs. Therefore, growth and properties of Zn₄Sb₃ and ZnSb films merit systematic study.

Zinc antimonide thin films have been produced on silica substrates at a substrate temperature (*T*_{sub}) of 473 - 573 K by a co-sputtering method. By a 'co-sputtering method' is understood a method in which material, such as Zn or Sb, is sputtered onto a substrate from a plurality of targets, such as from two targets, such as a Zn-Sb compound target and a pure Zn target. By controlling the growth parameters, for example, *T*_{sub}, three types of zinc antimonide films with different Zn:Sb atomic ratios of (type A) ∼50:50, (type B) ∼54:46 and (type C) ∼58:42 have been produced. XRD results revealed that type A samples are ZnSb films, but XRD patterns of type B and C samples are totally different to each other and cannot be assigned to well characterized Zn₄Sb₃, ZnSb, Zn₃Sb₂, Zn, and Sb, suggesting formation of two new zinc antimonide phases. Further studies have indicated that these two new phases are not stable at *T* ≥ 573 K, and type B and C films will separately evolve to Zn₄Sb₃+ZnSb and nearly phase-pure, such as phase-pure, Zn₄Sb₃ films after annealing (where the annealing step takes place after the deposition step) treatment under Ar atmosphere at 573 K. Thermoelectric transport properties of these different types of zinc antimonide films have been studied.

One zinc target (hereafter referred to as 'Zn target') and one specifically prepared Zn/Sb compound target (made by heating 99.995% zinc tablets and 99.995% Sb powder in an atomic ratio of 4:3 (hereafter referred to as 'compound target'), were employed in a co-sputtering system to produce zinc antimonide thin films. By carefully adjusting the *T*_{sub} and/or the magnetron power (*MP*) applied on the two targets (hereafter referred to, respectively, as *MP*_{compound target} and *MP*_{Zn target}), zinc antimonide films with different crystal structures and Zn:Sb atomic ratios were produced. FIG 1 shows X-ray diffraction (XRD) patterns of the samples produced with *MP*_{compound} target of 6 W / *MP*_{Zn target} of 10 W, Argon (Ar) pressure (*P*) of 0.6 Pa, growth time (*t*) of 1 hr, but with different *T*_{sub} of 548 K, 523 K and 473 K. These three XRD patterns are totally different from each other, implying formation of films with three different crystal structures. The composition of those films was examined by Energy Dispersive X-ray analysis (EDX) and Rutherford Backscattering Spectrometry (RBS). Except the signal coming from the silica substrate, Zn and Sb are the only two identified elements. The tested Zn:Sb atomic ratios of these three types of films are about 50:50 (type A), 54:46 (type B), and 58:42 (type C), respectively, which increase with decreasing *T*_{sub}. Both the XRD patterns and the EDX/RBS results confirmed that the type A films are nearly phase-pure, such as phase-pure, ZnSb films. While, the XRD patterns of the type B and C films do not match with any XRD patterns of silica, Zn, Sb, and all well characterized zinc antimonides, *i.e*. Zn₄Sb₃, ZnSb and a high temperature phase of Zn₃Sb₂. Additionally, these two XRD patterns, which respectively have the strongest peak at 23.75 ° (for type B) and 24.30 ° (for type C) do not share any peak at the same position. Considering that these films are polycrystalline films, it indicates the existence of two new phases of zinc antimonides. Apart from the reproducible growth of ZnSb, type B and type C films, double phased films of ZnSb + type B, type B + type C, and type C + Zn have also been obtained by adjusting growth parameters of *T*_{sub} and *MP.* This observation supports formation of zinc antimonides with two new crystal phases.

Annealing treatment under Ar atmosphere was used to study stability of the zinc antimonide films. It was revealed that an annealing treatment of 673 K will lead to apparent loss of zinc inside these film samples owing to the high vapor pressure of zinc and quite thin film thickness. However, the Zn:Sb atomic ratios of the zinc antimonide films kept nearly constant, such as constant, at an annealing temperature of 573 K. Thus all the annealing treatments were performed under Ar atmosphere (Ar pressure of 1.0 Pa) at 573 K using the sputtering chamber.

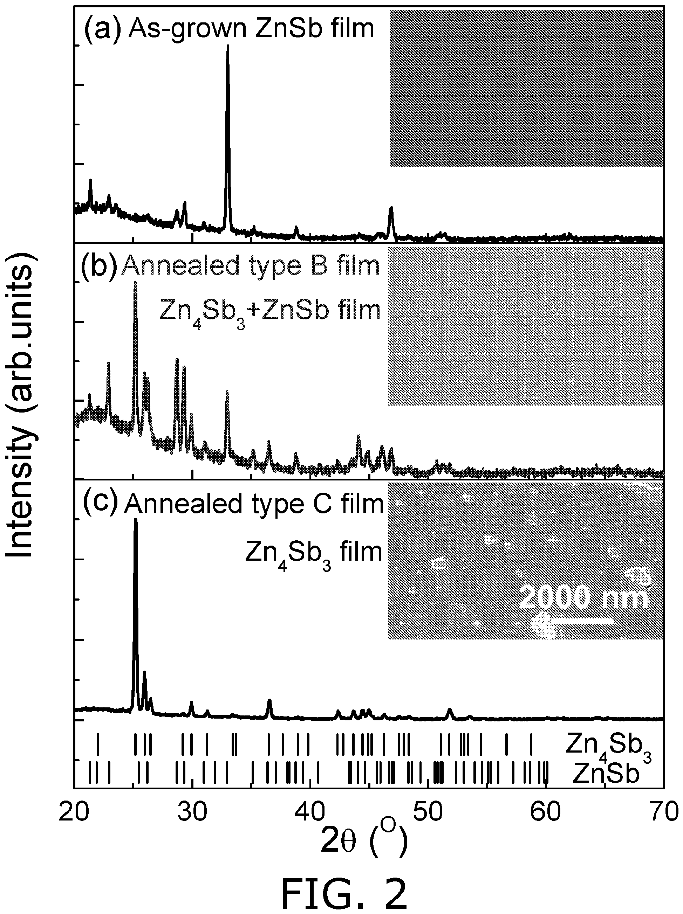

In this work, nearly phase-pure, such as phase-pure, ZnSb films were obtained at *T*_{sub} in the range of 548-573 K. FIG 2 (in the pattern in the top, which is labeled 'a') shows an XRD pattern of a ZnSb film grown with *MP*_{zinc target} of 12 W, *MP*_{compound target} of 5W, *P* of 0.6 Pa, *T*_{sub} of 573 K, and *t* of 2 hr. ZnSb (211) peak dominates the whole pattern, suggesting formation a <211>-textured ZnSb film.

Top-view SEM image of the ZnSb film is presented in the inset of FIG 2 (next to the pattern in the top, which is labeled 'a'). A very flat and continuous film can be observed. It was revealed that the nearly phase-pure, such as phase-pure, ZnSb films will keep their crystal structure after an annealing treatment at 573 K, only the peak intensity in their XRD patterns will be slightly enhanced. The stability of ZnSb films will be discussed further in the latter paragraph based on their thermoelectric properties.

According to the present application, growth of textured and nearly phase-pure, such as phase-pure, ZnSb films by a sputtering method was demonstrated by XRD and EDX results. The thermoelectric properties of these ZnSb films will be discussed and compared to ZnSb bulk materials in the latter paragraph.

Type B samples were produced at 523 K. It was revealed that type B film is not stable at *T* ≥ 573 K and an annealing treatment under Ar atmosphere at 573 K for a period of time, such as 2 hr, can change type B films into Zn₄Sb₃ + ZnSb films. The XRD pattern of an annealed type B film grown with *MP*_{zinc target} of 10 W, *MP*_{compound target} of 6W, *P* of 0.6 Pa, *T*_{sub} of 523 K, and *t* of 2 hr is presented in FIG 2 (in the pattern in the middle, which is labeled 'b'), and all the peaks in this XRD pattern can be assigned to Zn₄Sb₃ and/or ZnSb. The obtained Zn₄Sb₃ + ZnSb films are continuous and have a relatively smooth, such as smooth, top surface, which can be observed from a SEM image presented in the inset of FIG 2 (next to the pattern in the middle, which is labeled 'b'). No detectable changes of Zn:Sb atomic ratios from the as-deposited and annealed type B films were observed.

Type C samples are also not stable at annealing temperature of 573 K. It is demonstrated that "phase-pure" type C films will evolve to nearly phase-pure, such as phase-pure, Zn₄Sb₃ films after 2 hr annealing treatment. XRD pattern of an annealed type C film grown with *MP*_{zinc target} of 10 W, *MP*_{compound target} of 6W, *P* of 0.6 Pa, *T*_{sub} of 473 K, and *t* of 2 hr is shown in FIG 2 (in the pattern in the bottom, which is labeled 'c'). The dominating Zn₄Sb₃ (030) peak in the XRD pattern implies formation a <030>-textured Zn₄Sb₃ film. Since the Zn:Sb atomic ratio of Zn₄Sb₃ is 4:3, which is very close to that of type C film, i.e. 58:42, the structure evolvement of type C films to Zn₄Sb₃ films during annealing process can be rationally understood. Compared to flat top surface of ZnSb films and Zn₄Sb₃+ZnSb films shown in FIG 2, respectively (ZnSb in the pattern in the top, which is labeled 'a'; and Zn₄Sb₃+ZnSb in the pattern in the middle, which is labeled 'b'), there are some particle-like structures that can be observed on the surface of Zn₄Sb₃ films, which can also be observed from as-grown type C films and had been characterized as zinc-rich particles by EDX.
The reference entitled "Thermoelectric properties of Zn4Sb3 thin films prepared by magnetron sputtering", by Zhang, L.T., Tsutsui, M., Ito, K. & Yamaguchi, M. Thin Solid Films 443, 84-90 (2003) - which is hereafter referred to as Zhang2003 - reported growth of Zn₄Sb₃ films by sputtering Zn and Sb targets at room temperature (*RT*) and then subsequently, after sputtering, annealing under an Ar atmosphere at 573-673 K. Amorphous phase plus zinc were confirmed from the XRD pattern of deposited film at *RT*; and Zn₄Sb₃ plus Zn peaks were identified from XRD patterns of the annealed samples. In the present application, by sputtering a Zn/Sb compound target and a Zn target, such as sputtering a Zn/Sb compound target and a Zn target substantially simultaneously, such as simultaneously, type C films with Zn:Sb atomic ratio similar to Zn₄Sb₃ were produced at 473 K. By 'simultaneously' is understood that a plurality of events takes place simultaneously, i.e., within the same period of time, such as the time-period where the first event takes place overlaps with the time-period where the second event takes place. An annealing (where the annealing step takes place after the deposition step) treatment at 573 K for a period of time, such as several hours, could lead to a phase transition from type C films to nearly-phase pure, such as phase-pure Zn₄Sb₃ films. Compared to the Zn₄Sb₃ films reported in Zhang2003, which apparently contain zinc impurity and do not have preferable orientation, the Zn₄Sb₃ films produced in this work are nearly phase-pure, such as phase-pure, and <030>-textured films. The measured carrier concentration (*n*) of Zn₄Sb₃ films produced in this work at *RT* is about 2.8 × 10²⁰ cm⁻³, which is similar to the reported results of Zn₄Sb₃ films according to Zhang2003.
To confirm the phase transition of as-grown zinc antimonide films during annealing process, resistivity (ρ, rho) and carrier concentration (*n*) of as-deposited and annealed (Ar pressure of 1.0 Pa, 573 K, for 2 hr) zinc antimonide films were measured by room temperature Hall measurement. Since ρ values of the as-grown type B films are too large for Hall measurement, only ρ of as-grown type B films was roughly measured by a four-point probe method using a multimeter. The obtained room temperature ρ and *n* results are listed in TABLE I (inserted at end of the description) which shows resistivity and Hall carrier concentration of as-grown and annealed zinc antimonide films at room temperature.

The measured ρ and *n* of an as-grown ZnSb film at *RT* are 2.6 m*Ω* cm and 1.9 × 10¹⁹ cm⁻³, respectively. The annealing treatment only slightly changed ρ and *n* of this ZnSb film to 3.1 m*Ω* cm and 1.5 × 10¹⁹ cm⁻³. While, the as-grown type B film has a quite high room temperature ρ value of ∼650000 m*Ω* cm, which is 5 orders of magnitude larger than that of the annealed type B film, i.e. 4.9 m*Ω* cm. As for the type C films, the annealing treatment led to a decrease of p from 43.0 m*Ω* cm to 3.4 m*Ω* cm and increase of *n* from 3.6 × 10¹⁹ cm⁻³ to 2.8 × 10²⁰ cm⁻³. The large changes of ρ and *n* together with the totally changed XRD patterns provide solid evidence for both the phase transition of the type B film to Zn₄Sb₃+ZnSb films and the type C films to Zn₄Sb₃ films.

In the present application it is shown that ZnSb films can be produced directly at 548-573 K, and Zn₄Sb₃ films can be obtained through annealing type C films at 573 K. Their thermoelectric properties and stability are very interesting. Since it had been revealed that the film samples produced in this work will apparently loss some zinc at annealing temperature of 673 K, the thermoelectric properties and stability of the films in this work were investigated at *RT* ≤ *T* ≤ 573 K.

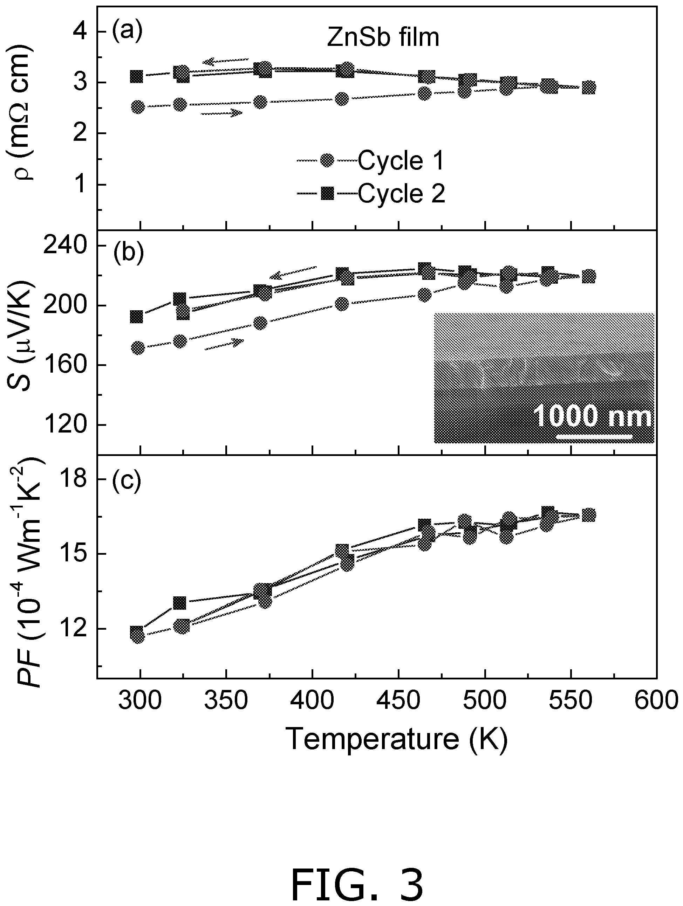

ρ and *S* of the film samples were measured simultaneously by an ULVAC-RIKO ZEM-3 thermoelectric property measurement system under an inert atmosphere (helium, He). FIG 3 respectively show ρ (in the top graph labelled 'a'), *S* (in the middle graph labelled 'b'), and *PF* (*in* the bottom graph labelled 'c') results of a ZnSb film grown at the same growth condition of the sample presented in FIG 2 (in the top graph labelled 'a'). The film thickness is 450 nm, which was measured from cross-sectional SEM image of the film (shown in the inset of FIG 3 next to the curve in the middle labelled 'b'). The thermoelectric measurements were subjected to two measurement cycles, i.e. *RT*-> 560 K-> *RT*-> 560 K-> *RT,* where room temperature (RT) is construed broadly as 298-325 K. In this work, the thermal cycling was carried out as follows: A maximum measurement temperature was defined, and how many data point there was to be obtained at that temperature, and then the measurement system automatically performed the measurement at the different temperatures. It can be seen that the measured ρ and *S* of the ZnSb film started to be stable after the heating process of first measurement cycle. ZnSb bulk material has previously been suggested to decompose to Zn and Sb at *T* ≥ 623 K. Due to the thin film thickness, stability of ZnSb films could be questioned for application. The thermal cycling measurement results here confirmed that the ZnSb films produced in this work present stable thermoelectric performance at *T* ≤ 573 K. The measured ρ (573K) and S (573K) of ZnSb film are 2.9 m*Ω* cm and 219 µVK⁻¹, respectively. As a result, the largest obtained PF value of ZnSb films is about 16.5 Wm⁻¹K⁻² at 573 K. All these results are consistent with the reported results on ZnSb single crystals, indicating good crystal quality of the ZnSb films.

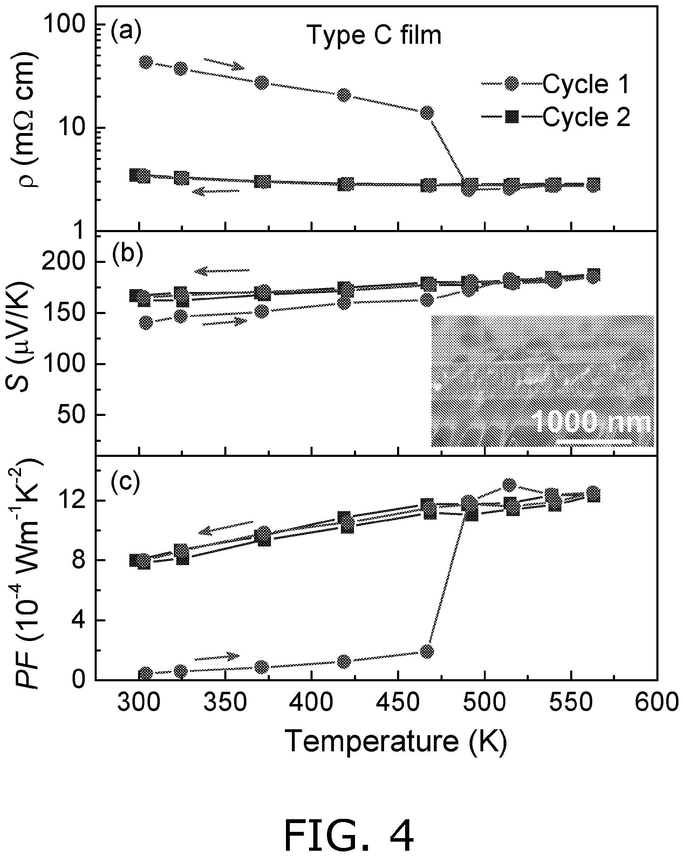

The thermoelectric properties of Zn₄Sb₃ films had been reported by Zhang2003. In this work, Zn₄Sb₃ films were obtained by annealing type C films at 573 K for a period of time, such as 1-3 hours. Thus type C films could evolve into Zn₄Sb₃ films during a thermoelectric measurement with measuring temperature up to ∼573 K. ρ(*T*) and *S*(*T*) results of a type C film grown with *MP*_{zinc target} of 10 W, *MP*_{compound target} of 6 W, *P* of 0.6 Pa, *T*_{sub} of 473 K, and *t of* 2 hr are respectively shown in FIG 4 in the top graph labelled 'a' and in the middle graph labelled 'b'. *PF*(T) results are shown in the bottom graph labelled 'c'. The thermoelectric measurements were subjected to two measurement cycles. The film thickness is about 540 nm, which was measured from cross-sectional SEM image presented in the inset of FIG 4 (shown in the inset of FIG 4 next to the curve in the middle labelled 'b'). No change of the film thickness was observed before and after the annealing treatment. During the heating process of the first measurement cycle, it can be seen that ρ(*T*) firstly decrease with increasing temperature from ρ(*RT*) of 37 mΩ cm to ρ(450K) of 16 mΩ cm, and then quickly drop to ∼3 mΩ cm at 450 K < T < 500 K. This indicates a phase transition of the film sample could happen at about 500 K. After that ρ(*T*) of this film sample kept stable at ∼3 mΩ cm over the measurement temperature range and during all other measurement cycles. This phenomenon can be rationally explained by considering the type C film changed to Zn₄Sb₃ films during the first heating process and then kept stable. It can be observed that the type C film have a much larger ρ than the Zn₄Sb₃ films, and ρ(*RT*) of the type C films is about 10 times of ρ(*RT*) of the Zn₄Sb₃ films. *S*(*T*) of the type C films and the Zn₄Sb₃ films are similar (Shown in FIG 4 in the graph in the middle labelled 'b'). The measured *S*(*RT*) and S(553 K) of Zn₄Sb₃ films are about 160 and 190 µVK⁻¹, respectively. FIG 4 shows (in the bottom graph labelled 'c') *PF*(*T*) of the type C and the Zn₄Sb₃ films. The largely improved thermoelectric performance from the type C films to the Zn₄Sb₃ films is clearly presented. The Zn₄Sb₃ films have a largest PF value of 12.0 × 10⁻⁴ Wm⁻¹K⁻² at 553 K.

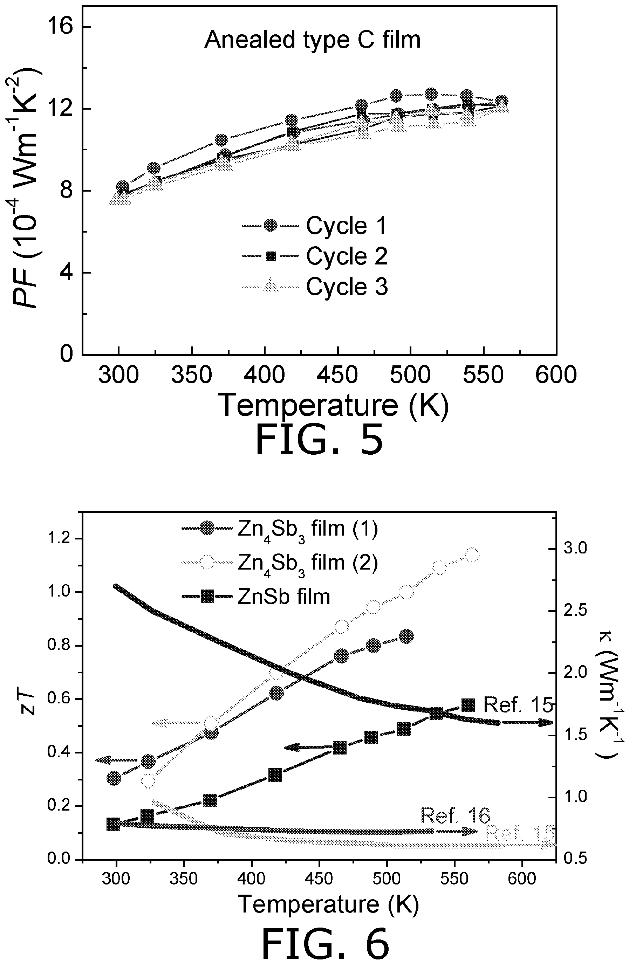

It is suggested that Zn₄Sb₃ could be unstable at *T* ≥ 523 K and single-phase Zn₄Sb₃ nanoparticles are not stable at *T* ≥ 473 K. However, the quite stable PF results of the Zn₄Sb₃ film during the two measurement cycles imply a good stability of Zn₄Sb₃ films with a low pressure of inert gas (Helium at a pressure of about 0.09 MPa) at T ≤ 573 K. In order to further confirm stability of the Zn₄Sb₃ films formed in this work, thermoelectric properties of some type C samples annealed at 573 K for 10 hr were studied. These annealed films had been confirmed to be phase-pure Zn₄Sb₃ films by XRD. FIG 5 shows PF(*T*) of an annealed type C sample subjected to three measurement cycles. It can be seen that the annealed sample presented stable thermoelectric performance and its PF values are consistent with the results shown in FIG 4 (in the bottom graph labelled 'c').

The largest PF value of ZnSb films in this work is about 16.5 ×10⁻⁴ Wm⁻¹K⁻² at 573 K. By assuming the thermal conductivity of the ZnSb films is equal to that of bulk ZnSb, i. e. ∼1.6 Wm⁻¹K⁻¹ at 573 K, the highest *zT* of ZnSb films is supposed to be 0.6 at 573 K, FIG 6, which is similar to the best reported *zT* of ZnSb bulk materials. The produced Zn₄Sb₃ films have a largest PF value of 12.0 × 10⁻⁴ Wm⁻¹K⁻² at 573 K. By using the reported thermal conductivity of Zn₄Sb₃ bulk materials of ∼0.6 Wm⁻¹K⁻¹ at 573 K, the highest *zT* of Zn₄Sb₃ films in this work is estimated to be 1.15 at 573 K, FIG 6, which is also similar to the highest *zT* of reported Zn₄Sb₃ bulk and thin films. Thermoelectric thin films could have much reduced lattice thermal conductivity and thus an enhanced *zT* compared to bulk thermoelectric materials.

In summary, synthesis of zinc antimonide films by a sputtering method was systematically studied. Except ZnSb films, two new phases of zinc antimonides were discovered from the as-grown samples, and their resistivity and stability were studied. After annealing treatment at 573 K, these two new phases of zinc antimonide films will evolve to Zn₄Sn₃+ZnSb and nearly phase pure, such as phase pure, Zn₄Sb₃ films through phase transitions. Thermoelectric properties and stability of textured, nearly phase-pure, such as phase-pure, Zn₄Sb₃ films and ZnSb films were investigated up to measuring temperature of 573 K. The largest PF of ZnSb and Zn₄Sb₃ films are 16.5 ×10⁻⁴Wm⁻¹K⁻² and 12.0 ×10⁻⁴Wm⁻¹K⁻² at 573 K, respectively. These results are comparable to the best reported results of ZnSb and Zn₄Sb₃ bulk materials, indicating promising application potential of these high performance and low cost films in electronic devices as power generators and thermoelectric sensors, such as laser radiation sensor.

FIG 1 shows XRD patterns of the samples grown with *MP*_{compound target} of 10 W/*MP*_{Zn target} of 6W, *P* of 0.6 Pa, *t* of 1 hr, but different *T*_{sub} of 548 K (Type A film, shown in the pattern in the top of the figure), 523 K (Type B film, shown in the pattern in the middle of the figure), and 473 K (Type C film, shown in the pattern in the bottom of the figure). Type A films has a Zn:Sb atomic ratio of ∼50:50 and was confirmed as ZnSb film. Type B and type C films respectively have atomic ratio of ∼54:46 and ∼58:42, but their XRD patterns cannot be assigned to crystal structures of Zn₄Sb₃, ZnSb, Zn and Sb.

In the following the diffraction peak locations for the type B film, the type C film, the ZnSb film and the Zn4Sb3 film are given in 2-theta angles (degrees) for an X-ray source of Cu-K_{α}. The intensity of the peaks may vary according to the method of measurement and the signal to noise ratio may also vary, but the angle of the peaks will only vary within the boundaries set by the measurement uncertainties of the equipment used for the measurements. Measurement uncertainties may amount to 0.01 degrees, such as 0.02 degrees, such as 0.05 degrees, such as 0.1 degrees, such as 0.2 degrees, such as 0.5 degrees, such as 1.0 degrees (given in 2-theta angles).

Diffraction peak locations for the type B film given in 2-theta angles (degrees): 23.8; 26.5; 27.5; 30.1; 36.7; 42.5; 43.7; 48.0; 48.8.

Diffraction peak locations for the type C film given in 2-theta angles (degrees): 24.3; 25.6; 31.2; 43.9; 49.9.

Diffraction peak locations for the ZnSb film given in 2-theta angles (degrees): 21.3325; 21.887; 22.9585; 25.4757; 26.2039; 28.6666; 28.6666; 29.2992; 30.9709; 31.9286; 32.9223; 35.1133; 36.375; 37.0586; 38.0636; 38.2471; 38.7395; 39.3704; 40.6583; 43.2879; 43.4529; 44.0279; 44.628; 45.6529; 45.9527; 46.6898; 46.9097; 47.0789; 47.0789; 48.3077; 48.6093; 49.3306; 50.5176; 50.6217; 50.7675; 50.7675; 51.0309; 51.2047; 51.2047; 52.333; 53.0026; 53.9199; 54.5227; 55.0767; 55.3115; 55.9176; 57.1944; 57.1944; 58.1615; 58.6027; 59.4077; 59.4077; 59.8174; 60.0655.

Diffraction peak locations for the Zn4Sb3 film given in 2-theta angles (degrees): 22.0327; 25.186; 25.9553; 26.4338; 29.1691; 29.9293; 31.2487; 33.4197; 33.7177; 36.4949; 37.6687; 38.9396; 39.8001; 42.2971; 42.7802; 43.6702; 44.4146; 44.8786; 45.1856; 46.2327; 47.4886; 47.9141; 48.3476; 51.068; 51.7513; 52.7471; 53.0437; 53.3774; 54.4753; 56.6289; 58.7224

FIG 2 shows XRD patterns of (a) a ZnSb film grown with *MP*_{compound target} of 12 W/*MP*_{Zn target} of 5W, *P* of 0.6 Pa, *T*_{sub} of 573 K, and *t* of 2 hr, (b) an annealed type B sample grown with *MP*_{compound target} of 10 W/*MP*_{Zn target} of 6 W, *P* Of 0.6 Pa, *T*_{sub} Of 523 K, and *t* of 2 hr, and (c) an annealed type B sample grown with *MP*_{compound target} of 10 W/*MP*_{Zn target} of 6 W, *P* of 0.6 Pa, *T*_{sub} of 473 K, and *t* of 2 h. The annealing (where the annealing step that takes place after the deposition step) treatment was performed under Ar atmosphere at 573 K for 2 h. The annealed type B film is confirmed to be a Zn₄Sb₃+ZnSb film. From the Zn:Sb ratio of 54:46 the ratio of Zn4Sb3:ZnSb can be calculated to be 27/73 based on a Zn:Sb ratio of 54/46. The annealed type C film is confirmed to be a nearly phase-pure, such as phase-pure, Zn₄Sb₃ film. Top view SEM images of the corresponding samples are presented in the inset of the figure next to the corresponding XRD pattern. The scale bar is applied to all the SEM images in this figure.

It is noted that the Zn:Sb ratio can be controlled by adjusting the growth conditions, thus the as-deposited films could be a combination of Zn, Sb, type B and type C, such as ZnSb, such as ZnSb+type B, such as type B, such as type B + type C, such as type C, such as type C + Zn, and the resulting thermoelectric zinc antimonide thin films, such as after an annealing step, could comprise a combination of Zn, Sb, ZnSb and Zn4Sb3, such as Sb+ZnSb, such as ZnSb, ZnSb + Zn4Sb3 (with various ZnSb to Zn4Sb3 ratios), such as Zn4Sb3, such as Zn4Sb3+Zn.

FIG 3 shows (a) p(T), (b) *S*(*T*), and (c) PF(*T*) of a ZnSb grown with *MP*_{zinc target} of 12 W, *MP*_{compound target} of 5W, *P* of 0.6 Pa, *T*_{sub} of 573 K, and *t* of 2 h. Two measurement cycles in the measurement temperature range of RT to 573 K were performed. Cross-sectional SEM image of this ZnSb film is shown in the inset of (b). TABLE II comprises data points corresponding to cycle 1 of FIG 3. TABLE III comprises data points corresponding to cycle 2 of FIG 3. In this work (such as for the data in FIGS 3-5), we defined the maximum measurement temperature and how many data points we wanted to obtain, and then allowed the measurement system (ULVAC RIKO ZEM-3) to automatically perform the measurement at different temperatures. A typical measurement cycle (RT -> 573 K -> RT) takes approximately 8-9 hours.

FIG 4 shows (a) ρ(*T*), (b) *S*(*T*), and (c) PF(*T*) of a type C film grown with *MP*_{zinc target} of 10 W, *MP*_{compound target} Of 6 W, *P* Of 0.6 Pa, *T*_{sub} Of 473 K, and *t* Of 2 h. Two measurement cycles in the measurement temperature range of RT to 573 K were performed. Cross-sectional SEM image of this type C film is shown in the inset of (b). TABLE IV comprises data points corresponding to cycle 1 of FIG 4. TABLE V comprises data points corresponding to cycle 2 of FIG 4.

FIG 5 shows PF(*T*) of an annealed type C sample subjected to three measurement cycles. This type C film was produced with *MP*_{zinc target} of 10 W, *MP*_{compound} target of 6W, *P* of 0.6 Pa, *T*_{sub} of 473 K, and *t* of 2 h. The annealing (where the annealing step takes place after the deposition step) treatment was performed under Ar atmosphere at 573 K for 10 hr. TABLE VI comprises data points corresponding to FIG 5.

FIG 6 shows zT of ZnSb and Zn₄Sb₃ films. In the literature two different values for the lattice thermal conductivity of bulk Zn4Sb3 have been given leading to slightly different zT curves. TABLE VII comprises data points corresponding to the two Zn4Sb3 data sets shown in FIG 6. TABLE VIII comprises data points corresponding to the ZnSb data set shown in FIG 6.

### Methods

Zinc antimonide films were deposited on polished fused silica substrates by co-sputtering of a Zn target and a specifically prepared Zn/Sb compound target. The 1-inch compound targets were made by heating 99.995% Zn ingots and 99.995% Sb powder in an atomic ratio of 4:3 in a corundum crucible for reaction and subsequent annealing treatment by using an induction furnace with ∼1 MPa Ar atmosphere. The sputtering system was equipped with two independent magnetron sources with the target-to-substrate distance of 10 cm. The chamber base pressure was approximately 1×10⁻⁵ Pa. Ar (purity 99.9996%) was used as sputter-gas at a flow rate of 10 sccm and the Ar pressures in the chamber was fixed at 0.6 Pa. In order control the thin film growth, different magnetron power of 5-12 W, substrate temperatures of 473-573 K and deposition times of 1- 3 hr were applied. The annealing (where the annealing step takes place after the deposition step) treatment of the film samples was performed with Ar pressure of ∼1.0 Pa at 573 K using the vacuum chamber of the sputtering system.

The as-deposited and annealed samples were characterized and analyzed by scanning electron microscopy (SEM, Nova600 NanoLab, FEI) with Energy Dispersive X-ray analysis (EDX), X-ray diffraction (XRD, D8 Discover, Bruker AXS) in *θ*-2*θ* geometry with CuK_{α} radiation, and Rutherford Backscattering Spectrometry (RBS, using 2 MeV ⁴He⁺ and a scattering angle of 161°). The RBS spectra were simulated using the SIMNRA software which is described in the reference "Ion beam analysis of rough thin films" by Mayer, M. Nucl. Instr. Meth. B 194, 177-186 (2002). Regarding the XRD measurements, it is understood that the peak positions are determined only within an accuracy of approximately 0.2 degrees, and the resulting patterns have a detection limit of 1-2 wt%.
The Seebeck coefficient and electrical resistivity were simultaneously measured from room temperature to 573 K under an inert atmosphere (He) using two ULVAC-RIKO ZEM-3 thermoelectric property measurement systems. Room temperature Hall measurement was performed using a Quantum Design physical property measurement system. Hall resistivity (*ρ*_{H}) of the zinc antimonide films was measured while sweeping the magnetic field (*B*) in two opposite directions in the AC transport option. Gold wires were mounted on the film using conducting silver paste. After eliminating the resistive contributions to *ρ*_{H} by taking the average values in the two fields, the Hall coefficient (*R*_{H}) was determined by *ρ*_{H} = *R*_{H}*B.*

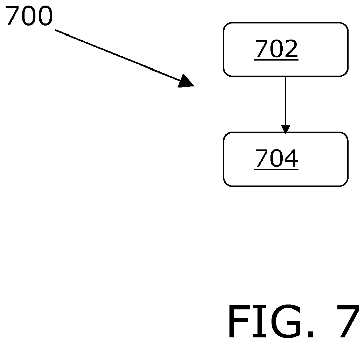

FIG 7 shows a method 700 for producing a zinc antimonide thin film, the method comprising deposition 702 of zinc and antimony on a substrate wherein the deposited zinc and antimony form a layer of zinc antimonide, wherein the substrate during deposition has a temperature of at least 100 degrees Celsius, such as at least 200 degrees Celsius. In the particular example depicted, the method furthermore comprises an annealing step 704, wherein the substrate subsequent to deposition of zinc and antimony is kept at an elevated temperature for a period of time, such as a temperature within 473-837 Kelvin, such as within 473-673 Kelvin, such as within 473-672 Kelvin, such as within 473-623 Kelvin, such as within 523-623 Kelvin, for a period of time, wherein the period of time is within 0.01-72 hours, such as within 0.01-24 hours, such as within 0.1-24 hours, such as within 0.5-24 hours, such as within 1-24 hours, such as within 1-12 hours, such as within 1-6 hours, such as within 1-3 hours, such as 2-3 hours, such as 0.01-3 hours, such as at least 2 hours, such as at most 3 hours, such as 2 hours.

To sum up, there is provided a method for manufacturing a thermoelectric zinc antimonide thin film wherein zinc and antimony are deposited on a hot substrate and wherein the deposited zinc and antimony form a layer of zinc antimonide. The substrate has a temperature of at least 100 degrees Celsius during deposition. The invention furthermore relates to fabrication of phase pure Zn4Sb3 thermoelectric thin films and phase pure thermoelectric ZnSb thin films, and furthermore to a zinc antimonide thin film comprising a mixture of the phases, such as ZnSb and Zn4Sb3, and still further relates to two completely new and hitherto unknown phases of zinc antimonide.

**TABLE I**

| Sample | Resistivity (mΩcm) | Carrier concentration (cm⁻³) |
|---|---|---|
| As-grown ZnSb film | 2.6 | 1.9 × 10¹⁹ |
| Annealed ZnSb film | 3.1 | 1.5 × 10¹⁹ |
| As-grown type B film | ∼650000 | - |
| Annealed type B film (Zn₄Sb₃+ZnSb film) | 4.9 | 4.66 × 10¹⁹ |
| As-grown type C film | 43.0 | 3.6 × 10¹⁹ |
| Annealed type C film (Zn₄Sb₃ film) | 3.4 | 2.8 × 10²⁰ |

**TABLE II (corresponds to FIG 3 cycle 1)**

| T(K) | Rho (mohm cm) | S (µVK⁻¹) | PF(10⁻⁴ Wm⁻¹K⁻²) |
|---|---|---|---|
| 298,8314 | 2,51625 | 171,335 | 11,66643 |
| 323,2002 | 2,55795 | 175,8418 | 12,08795 |
| 369,6973 | 2,60735 | 187,9594 | 13,54965 |
| 417,1785 | 2,67003 | 200,5971 | 15,07068 |
| 465,2517 | 2,77709 | 206,5971 | 15,36943 |
| 488,3169 | 2,81906 | 214,5558 | 16,32961 |
| 512,6175 | 2,87382 | 212,1237 | 15,65736 |
| 535,981 | 2,91663 | 217,0374 | 16,15055 |
| 560,6791 | 2,90202 | 219,2516 | 16,56474 |
| 539,1857 | 2,92121 | 219,2333 | 16,45317 |
| 514,2158 | 2,98938 | 221,6495 | 16,43436 |
| 491,3814 | 3,03864 | 217,9946 | 15,63912 |
| 467,5951 | 3,102 | 221,8844 | 15,87126 |
| 420,3333 | 3,2722 | 218,2048 | 14,55087 |
| 372,4643 | 3,28392 | 207,1426 | 13,06612 |
| 324,7898 | 3,2063 | 196,573 | 12,05157 |

**TABLE III (corresponds to FIG 3 cycle 2)**

| T(K) | Rho (mohm cm) | S (µVK⁻¹) | PF (10⁻⁴ Wm⁻¹K⁻²) |
|---|---|---|---|
| 297,754 | 3,12225 | 192,4701 | 11,86474 |
| 322,9767 | 3,1974 | 204,1484 | 13,03451 |
| 369,3123 | 3,27271 | 209,6735 | 13,43322 |
| 417,3126 | 3,22675 | 221,0747 | 15,1465 |
| 465,1246 | 3,11565 | 224,3831 | 16,15964 |
| 488,2667 | 3,04075 | 222,3936 | 16,26539 |
| 512,5231 | 2,98948 | 219,6433 | 16,13764 |
| 536,5301 | 2,95473 | 221,914 | 16,6668 |
| 560,1294 | 2,89821 | 218,9979 | 16,54816 |
| 538,5704 | 2,90427 | 218,829 | 16,48816 |
| 515,0823 | 2,99462 | 220,5228 | 16,23923 |
| 491,5331 | 3,05571 | 220,2505 | 15,87532 |
| 467,5869 | 3,11633 | 221,4118 | 15,73108 |
| 420,4301 | 3,21484 | 217,7215 | 14,74493 |
| 372,521 | 3,22143 | 208,9979 | 13,55922 |
| 324,7705 | 3,11961 | 194,6287 | 12,14264 |

**TABLE IV (corresponds to FIG 4 cycle 1)**

| T(K) | Rho (mohm cm) | S (µVK⁻¹) | PF (10⁻⁴ Wm⁻¹K⁻²) |
|---|---|---|---|
| 304,1415 | 42,9953 | 140,3301 | 0,45802 |
| 324,3113 | 37,03223 | 146,2935 | 0,57792 |
| 370,9957 | 27,13571 | 151,279 | 0,84337 |
| 418,7521 | 20,71756 | 159,6346 | 1,23003 |
| 466,8207 | 13,94671 | 162,835 | 1,90118 |
| 490,9317 | 2,49666 | 172,4024 | 11,90496 |
| 514,372 | 2,57314 | 183,0115 | 13,0165 |
| 538,8357 | 2,71918 | 183,3922 | 12,36869 |
| 562,8701 | 2,72672 | 184,6821 | 12,50861 |
| 540,9132 | 2,7361 | 180,6281 | 11,92448 |
| 516,6469 | 2,76689 | 179,0252 | 11,5834 |
| 492,454 | 2,79173 | 181,0124 | 11,73665 |
| 468,4537 | 2,73948 | 177,521 | 11,50352 |
| 420,8467 | 2,82416 | 172,497 | 10,53594 |
| 372,6227 | 2,97953 | 170,9934 | 9,8132 |
| 324,9631 | 3,24438 | 167,4065 | 8,63799 |

**TABLE V (corresponds to FIG 4 cycle 2)**

| T(K) | Rho (mohm cm) | S (µVK⁻¹) | PF (10⁻⁴ Wm⁻¹K⁻²) |
|---|---|---|---|
| 298,293 | 3,48903 | 167,1857 | 8,01112 |
| 323,7615 | 3,31248 | 169,6283 | 8,68647 |
| 370,2731 | 3,00645 | 169,9875 | 9,61127 |
| 418,5132 | 2,81174 | 174,605 | 10,8427 |
| 466,6209 | 2,74798 | 179,5928 | 11,7372 |
| 490,1247 | 2,76195 | 180,0244 | 11,73402 |
| 514,4893 | 2,77408 | 181,1529 | 11,82966 |
| 538,9509 | 2,76918 | 184,9236 | 12,34905 |
| 563,0274 | 2,85911 | 187,7379 | 12,32743 |
| 540,6003 | 2,86928 | 183,1676 | 11,69295 |
| 516,3578 | 2,84975 | 180,2317 | 11,39871 |
| 492,4657 | 2,84446 | 177,3935 | 11,06306 |
| 468,3658 | 2,82362 | 177,5632 | 11,16604 |
| 420,5117 | 2,87876 | 171,7009 | 10,24095 |
| 372,6354 | 3,01454 | 168,0276 | 9,36569 |
| 325,2112 | 3,23466 | 161,9843 | 8,11179 |

**TABLE VI (corresponds to FIG 5)**

| T Cycle1 (K) | PF Cycle1 (10⁻⁴ Wm⁻¹K⁻²) | T Cycle2 (K) | PF Cycle2 (10⁻⁴ Wm⁻¹K⁻²) | T Cycle3 (K) | PF Cycle3 (10⁻⁴ Wm⁻¹K⁻²) |
|---|---|---|---|---|---|
| 302,8623 | 8,18013 | 303,2072 | 7,85724 | 298,1891 | 7,53445 |
| 323,9376 | 9,08877 | 323,8764 | 8,33213 | 323,993 | 8,36868 |
| 370,3803 | 10,46281 | 370,3199 | 9,61676 | 370,2673 | 9,36169 |
| 418,3456 | 11,41731 | 418,3026 | 10,85531 | 418,2547 | 10,2844 |
| 466,4188 | 12,13853 | 466,4037 | 11,74137 | 466,2139 | 11,27077 |
| 489,9994 | 12,61578 | 490,1467 | 11,76311 | 489,9678 | 11,47556 |
| 514,2898 | 12,6913 | 514,1573 | 11,99995 | 514,2138 | 11,873 |
| 538,5978 | 12,61474 | 538,7614 | 12,2052 | 538,6983 | 11,63204 |
| 562,5033 | 12,34718 | 562,6401 | 12,12902 | 562,729 | 12,00808 |
| 539,764 | 12,10672 | 539,8225 | 11,81532 | 539,826 | 11,35695 |
| 515,6922 | 11,94668 | 515,5505 | 11,67971 | 515,648 | 11,21617 |
| 491,6538 | 11,72653 | 491,516 | 11,6272 | 491,6709 | 11,11115 |
| 467,6306 | 11,43226 | 467,5771 | 11,00933 | 467,6851 | 10,75613 |
| 419,9772 | 10,83374 | 419,8752 | 10,23306 | 419,9 | 10,15946 |
| 373,2158 | 9,7356 | 373,2387 | 9,54434 | 373,2581 | 9,20954 |
| 325,5554 | 8,40175 | 325,5578 | 8,4932 | 325,6191 | 8,2263 |
| 303,3458 | 7,86667 | 303,1881 | 7,73822 | 303,4727 | 7,5691 |

**TABLE VII (corresponds to FIG 6 Zn4Sb3)**

| T (K) | K1 (Wm⁻¹K⁻¹) | ZT1 | K2 (Wm⁻¹K⁻¹) | ZT2 |
|---|---|---|---|---|
| 298,293 | 0,79 | 0,30249 | | |
| 323,7615 | 0,77 | 0,36524 | 0,96 | 0,29295 |
| 370,2731 | 0,75 | 0,47451 | 0,71 | 0,5084 |
| 418,5132 | 0,73 | 0,62162 | 0,65 | 0,69813 |
| 466,6209 | 0,72 | 0,76067 | 0,63 | 0,86934 |
| 490,1247 | 0,72 | 0,79877 | 0,61 | 0,94281 |
| 514,4893 | 0,73 | 0,83373 | 0,61 | 0,99774 |
| 538,9509 | -- | -- | 0,61 | 1,09107 |
| 563,0274 | -- | -- | 0,61 | 1,13782 |

**TABLE VIII (corresponds to FIG 6 ZnSb)**

| T (K) | K1 (Wm⁻¹K⁻¹) | ZT1 |
|---|---|---|
| 297,754 | 2,7 | 0,13084 |
| 322,9767 | 2,5 | 0,16192 |
| 369,3123 | 2,25 | 0,22049 |
| 417,3126 | 2 | 0,31604 |
| 465,1246 | 1,8 | 0,41757 |
| 488,2667 | 1,74 | 0,45643 |
| 512,5231 | 1,7 | 0,48652 |
| 536,5301 | 1,63 | 0,54526 |
| 560,1294 | 1,6 | 0,57572 |

Although the present invention has been described in connection with the specified embodiments, it should not be construed as being in any way limited to the presented examples. The scope of the present invention is set out by the accompanying claim set. In the context of the claims, the terms "comprising" or "comprises" do not exclude other possible elements or steps. Also, the mentioning of references such as "a" or "an" etc. should not be construed as excluding a plurality. The use of reference signs in the claims with respect to elements indicated in the figures shall also not be construed as limiting the scope of the invention. Furthermore, individual features mentioned in different claims, may possibly be advantageously combined, and the mentioning of these features in different claims does not exclude that a combination of features is not possible and advantageous.

## Claims

1. A method for manufacturing a phase pure thermoelectric zinc antimonide thin film, the method comprising deposition of zinc and antimony on a substrate wherein the deposited zinc and antimony form a layer of zinc antimonide, wherein the substrate during deposition has a temperature of at least 100 degrees Celsius.

2. A method according to any of the preceding claims, wherein the substrate during deposition has a temperature of at least 200 degrees Celsius.

3. A method according to any of the preceding claims, wherein the zinc and the antimony is deposited in quantities corresponding to an atomic zinc:antimony ratio within 70:30 and 40:60.

4. A method according to any of the preceding claims, wherein the method further comprises an annealing step, wherein the substrate subsequent to deposition of zinc and antimony is kept at an elevated temperature for a period of time, such as wherein said period of time is within 0.01-72 hours.

5. A method according to any of the preceding claims, wherein the thermoelectric zinc antimonide thin film is phase pure Zn4Sb3

6. A method according to any one of the claims 1-4, wherein the thermoelectric zinc antimonide thin film is phase pure ZnSb.

7. A thermoelectric zinc antimonide thin film wherein the thermoelectric zinc antimonide thin film is phase pure, such as wherein the thermoelectric zinc antimonide thin film is phase pure Zn4Sb3 or wherein the thermoelectric zinc antimonide thin film is phase pure ZnSb.

8. A thermoelectric zinc antimonide thin film according to claim 7, wherein the thermoelectric zinc antimonide thin film has a thickness within 1-100000 nm, and/or wherein the thermoelectric zinc antimonide thin film has a power factor of at least 1.0x10⁻⁴ Wm⁻¹K⁻² at 573 K.

9. A thermoelectric zinc antimonide thin film according to claim 8, wherein the power factor is measured after one complete thermal cycle, wherein a thermal cycle is understood to be the process of changing the temperature of the thermoelectric thin film from room temperature to 573 Kelvin and back to room temperature.

10. Use of the thermoelectric zinc antimonide thin film according to any of claims 7-9, for converting thermal energy into electrical energy, for converting electrical energy into thermal energy, for cooling and/or for sensing.

11. A thermoelectric zinc antimonide thin film according to claim 7, which has X-ray powder diffraction peaks at 23.8, 30.1 and 48.8 degrees two-theta with copper as an X-ray source.

12. A thermoelectric zinc antimonide thin film according to claim 7, which has X-ray powder diffraction peaks at 24.4, 43.9 and 49.9 degrees two-theta with copper as an X-ray source.

13. A method according to any one of claims 1-6, wherein Zn and Sb are deposited on the substrate using a target with a Zn:Sb atomic ratio of at least 60:40.

14. A method according to any one of claims 1-6, 13, for preparing a thermoelectric zinc antimonide thin film comprising Zn4Sb3 wherein the Zn and Sb are deposited on a substrate, where the substrate has a temperature of at least 230 degrees Celsius (503 K).

15. A method according to any one of claims 1-6, 13-14, for preparing a thermoelectric zinc antimonide thin film comprising Zn4Sb3, wherein Zn and Sb are deposited on the substrate using at least a first and a second target, wherein the zinc concentration in the first target is higher than the zinc concentration in the second target, and wherein the magnetron power of the first target is higher than the magnetron power of the second target, and wherein the substrate temperature is at least 230 degrees Celsius (503 K).

## Patentansprüche

1. Verfahren zum Herstellen eines phasenreinen thermoelektrischen Zinkantimonid-Dünnfilms, das Verfahren umfassend Ablagerung von Zink und Antimon auf einem Substrat, wobei das abgelagerte Zink und Antimon eine Schicht von Zinkantimonid bilden, wobei das Substrat während der Ablagerung eine Temperatur von zumindest 100 Grad Celsius aufweist.

2. Verfahren nach einem der vorhergehenden Ansprüche, wobei das Substrat während der Ablagerung eine Temperatur von zumindest 200 Grad Celsius aufweist.

3. Verfahren nach einem der vorhergehenden Ansprüche, wobei das Zink und das Antimon in Mengen entsprechend einem atomaren Zink-Antimon-Verhältnis innerhalb von 70:30 und 40:60 abgelagert werden.

4. Verfahren nach einem der vorhergehenden Ansprüche, wobei das Verfahren ferner einen Glühschritt umfasst, wobei das Substrat nach der Ablagerung von Zink und Antimon über einen Zeitraum auf einer erhöhten Temperatur gehalten wird, etwa wobei der Zeitraum innerhalb von 0,01-72 Stunden liegt.

5. Verfahren nach einem der vorhergehenden Ansprüche, wobei der thermoelektrischen Zinkantimonid-Dünnfilm phasenreines Zn4Sb3 ist

6. Verfahren nach einem Ansprüche 1-4, wobei der thermoelektrischen Zinkantimonid-Dünnfilm phasenreines ZnSb ist.

7. Thermoelektrischer Zinkantimonid-Dünnfilm, wobei der thermoelektrische Zinkantimonid-Dünnfilm phasenrein ist, etwa wobei der thermoelektrische Zinkantimonid-Dünnfilm phasenreines Zn4Sb3 ist oder wobei der thermoelektrische Zinkantimonid-Dünnfilm phasenreines ZnSb ist.

8. Thermoelektrischer Zinkantimonid-Dünnfilm nach Anspruch 7, wobei der thermoelektrische Zinkantimonid-Dünnfilm eine Dicke innerhalb von 1-100000 nm aufweist, und/oder
wobei der thermoelektrische Zinkantimonid-Dünnfilm einen Leistungsfaktor von zumindest 1,0x10⁻⁴ Wm⁻¹K⁻² bei 573 K aufweist.

9. Thermoelektrischer Zinkantimonid-Dünnfilm nach Anspruch 8, wobei der Leistungsfaktor nach einem vollständigen thermischen Zyklus gemessen wird, wobei unter einem thermischen Zyklus der Prozess des Änderns der Temperatur des thermoelektrischen Dünnfilms von Raumtemperatur auf 573 Kelvin und zurück auf Raumtemperatur verstanden wird.

10. Verwendung des thermoelektrischen Zinkantimonid-Dünnfilms nach einem der Ansprüche 7-9 zum Umwandeln von thermischer Energie in elektrische Energie, zum Umwandeln von elektrischer Energie in thermische Energie, zum Kühlen und/oder zum Erfassen.

11. Thermoelektrischer Zinkantimonid-Dünnfilm nach Anspruch 7, der Röntgenpulverbeugungsspitzen bei 23,8, 30,1 und 48,8 Grad Zwei-Theta mit Kupfer als eine Röntgenquelle aufweist.

12. Thermoelektrischer Zinkantimonid-Dünnfilm nach Anspruch 7, der Röntgenpulverbeugungsspitezn bei 24,4, 43,9 und 49,9 Grad Zwei-Theta mit Kupfer als eine Röntgenquelle aufweist.

13. Verfahren nach einem der Ansprüche 1-6, wobei Zn und Sb unter Verwendung eines Ziels mit einem atomaren Zn-Sb-Verhältnis von zumindest 60:40 abgelagert sind.

14. Verfahren nach einem der Ansprüche 1-6, 13 zum Herstellen eines thermoelektrischen Zinkantimonid-Dünnfilms umfassend Zn4Sb3, wobei das Zn und Sb auf einem Substrat abgelagert sind, wobei das Substrat eine Temperatur von zumindest 230 Grad Celsius (503 K) aufweist.

15. Verfahren nach einem der Ansprüche 1-6, 13-14 zum Herstellen eines thermoelektrischen Zinkantimonid-Dünnfilms umfassend Zn4Sb3, wobei das Zn und Sb auf dem Substrat unter Verwendung von zumindest einem ersten und einem zweiten Ziel abgelagert sind, wobei die Zinkkonzentration in dem ersten Ziel höher als die Zinkkonzentration in dem zweiten Ziel ist, und wobei die Magnetron-Leistung des ersten Ziels höher als die Magnetron-Leistung des zweiten Ziels ist, und wobei die Substrattemperatur zumindest 230 Grad Celsius (503 K) beträgt.

## Revendications

1. Procédé de fabrication d'une couche mince d'antimoniure de zinc thermoélectrique en phase pure, le procédé comprenant le dépôt de zinc et d'antimoine sur un substrat, dans lequel le zinc et l'antimoine déposés forment une couche d'antimoniure de zinc, dans lequel, pendant le dépôt, le substrat a une température d'au moins 100 °C.

2. Procédé selon l'une quelconque des revendications précédentes, dans lequel, pendant le dépôt, le substrat a une température d'au moins 200 °C

3. Procédé selon l'une quelconque des revendications précédentes, dans lequel le zinc et l'antimoine sont déposés en quantités qui correspondent à un rapport atomique zinc:antimoine dans la plage de 70:30 à 40:60.

4. Procédé selon l'une quelconque des revendications précédentes, dans lequel le procédé comprenant en outre une étape de recuit, dans lequel le substrat subséquent au dépôt de zinc et d'antimoine est gardé à une température élevée pour une période, par exemple, ladite période variant dans la plage de 0,01 à 72 heures.

5. Procédé selon l'une quelconque des revendications précédentes, dans lequel la couche mince d'antimoniure de zinc thermoélectrique est du Zn4Sb3 en phase pure

6. Procédé selon l'une quelconque des revendications 1 à 4, dans lequel la couche mince d'antimoniure de zinc thermoélectrique est du ZnSb en phase pure.

7. Couche mince d'antimoniure de zinc thermoélectrique, dans laquelle la couche mince d'antimoniure de zinc thermoélectrique est en phase pure, par exemple, la couche mince d'antimoniure de zinc thermoélectrique étant du Zn4Sb3 en phase pure ou la couche mince d'antimoniure de zinc thermoélectrique étant du ZnSb en phase pure.

8. Couche mince d'antimoniure de zinc thermoélectrique selon la revendication 7, dans laquelle la couche mince d'antimoniure de zinc thermoélectrique a une épaisseur dans la plage de 1 à 100 000 nm, et/ou dans laquelle la couche mince d'antimoniure de zinc thermoélectrique a un facteur de puissance d'au moins 1,0 x 10⁻⁴ Wm⁻¹K⁻² à 573 K.

9. Couche mince d'antimoniure de zinc thermoélectrique selon la revendication 8, dans laquelle le facteur de puissance est mesuré après un cycle thermique complet, dans laquelle un cycle thermique est compris pour être le procédé de modification de la température de la couche mince thermoélectrique de la température ambiante à 573 K et puis de retour à la température ambiante.

10. Utilisation de la couche mince d'antimoniure de zinc thermoélectrique selon l'une quelconque des revendications 7 à 9, pour la conversion d'énergie thermique en énergie électrique, la conversion d'énergie électrique en énergie thermique, le refroidissement et/ou la détection.

11. Couche mince d'antimoniure de zinc thermoélectrique selon la revendication 7, laquelle a des crêtes de diffraction aux rayons X sur poudre à 23,8, à 30,1 et à 48,8 degrés deux thêta avec du cuivre comme source de rayons X.

12. Couche mince d'antimoniure de zinc thermoélectrique selon la revendication 7, laquelle a des crêtes de diffraction aux rayons X sur poudre à 24,4, à 43,9 et à 49,9 degrés deux thêta avec du cuivre comme source de rayons X.

13. Procédé selon l'une quelconque des revendications 1 à 6, dans lequel le Zn et le Sb sont déposés sur le substrat en utilisant une cible avec un rapport atomique Zn:Sb d'au moins 60:40.

14. Procédé selon l'une quelconque des revendications 1 à 6, 13, pour la préparation d'une couche mince d'antimoniure de zinc thermoélectrique comprenant du Zn4Sb3, dans lequel le Zn et le Sb sont déposés sur un substrat, dans lequel le substrat a une température d'au moins 230 °C (503 K).

15. Procédé selon l'une quelconque des revendications 1 à 6, 13 et 14, pour la préparation d'une couche mince d'antimoniure de zinc thermoélectrique comprenant du Zn4Sb3, dans lequel le Zn et le Sb sont déposés sur le substrat en utilisant au moins une première et une seconde cible, dans lequel la concentration de zinc dans la première cible est supérieure à la concentration de zinc dans la seconde cible, et dans lequel la puissance magnétron de la première cible est supérieure à la puissance magnétron de la seconde cible, et dans lequel la température du substrat est d'au moins 230 °C (503 K).
